# EUROPEAN PATENT SPECIFICATION

(11) **EP 2 128 705 B1**
(45) Date of publication and mention of the grant of the patent: **02.03.2016**
(21) Application number: 09159569.4
(22) Date of filing: 06.05.2009
(51) Int. Cl.: G03F 7/34, B41F 13/18

(54) **Apparatus and method for treating a cylindrically-shaped element using a clamp assembly**
Vorrichtung und Verfahren zur Bearbeitung eines zylindrischen Elements unter Verwendung einer Klemmenanordnung
Appareil et procédé pour traiter un élément de forme cylindrique en utilisant un ensemble de serrage

(30) Priority: 27.05.2008 US 130007 P; 29.04.2009 US 431780
(43) Date of publication of application: 02.12.2009
(73) Proprietor: E. I. du Pont de Nemours and Company, Wilmington, DE 19805 (US)
(72) Inventor: Luetke, Helmut, 60437 Frankfurt am Main (DE); Arnold, Carl, Bernard, Newark, DE 19711 (US); Joergensen, Soeren, 5260, Odense S. (DK); Koch, Andreas, 65185, Wiesbaden (DE); McMillen, Robert, A., Downingtown, PA 19335 (US); Vestergaard, IB, 5690, Tommerup (DK)
(74) Representative: Towler, Philip Dean

(56) References cited:
- EP-A2- 1 850 183
- US-A- 3 672 018
- US-A- 4 372 205
- US-A- 4 470 183
- US-A- 4 487 122

## Description

### BACKGROUND OF THE INVENTION

### Field of the Invention

This invention pertains to an apparatus and process for treating a cylindrically-shaped element. In particular, the apparatus and process can be used to prepare a cylindrically-shaped printing form from the element by thermal treatment. In particular, the apparatus and process can also be used to prepare a cylindrically-shaped photosensitive element.

### Description of Related Art

Flexographic printing plates are well known for use in relief printing on a variety of substrates and can be prepared from photosensitive printing elements containing a layer of a photosensitive composition such as those described in U.S. Patents 4,323,637 and 4,427,759. Photosensitive elements generally have the layer of the photopolymerizable composition interposed between a support and a cover sheet or multilayer cover element. Upon imagewise exposure of the photosensitive element to actinic radiation, photopolymerization of the photosensitive composition occurs in the exposed areas, thereby curing and rendering insoluble the exposed areas of the layer. Conventionally, the element is treated with a suitable solution to remove areas of the photopolymerizable layer that were not exposed and leaving a printing relief which can be used for flexographic printing.

As an alternative to solution development, a "dry" thermal development process may be used which removes the unexposed areas without the subsequent time-consuming drying step. In a thermal development process, the composition layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens) and 5,279, 697 (Peterson et al.). The exposed portions of the composition layer remain hard, that is, do not soften or melt, at the softening temperature for the unexposed portions. The absorbent material collects the softened un-irradiated material and then is separated and/or removed from the composition layer.

Processors for thermal development of flexographic printing elements are known, for example, from U.S. Patent 5,279,697 and U.S. Patent 6,797,454. In both processing apparatuses an irradiated photosensitive element comprising the support and the composition layer is mounted on a drum and a continuous web of absorbent material is passed over a hot roll. The photosensitive element most typically has a planar or plate-like shape, and is fully supported on the drum. The hot roll is urged towards the drum pressing the web against the planar photosensitive element and forming a nip. Heat is transferred by conduction from the hot roll, through the absorbent web, to the photosensitive element upon contact so that the temperature of the composition layer is raised sufficiently to enable the unirradiated portions of the composition layer to liquefy and be absorbed into the absorbent material. As the drum and hot roll rotate in contact together, the web is pressed against the photosensitive element to absorb the liquefied unirradiated composition and is then separated from the element. After the unirradiated composition is removed the resulting element has a raised relief surface of hardened areas that is suitable use as a printing plate.

Besides flat or planar photosensitive elements, it is also possible to thermally process cylindrically-shaped photosensitive printing elements, such as seamless photopolymer sleeves, or so called plate-on-sleeves. Seamless photopolymer sleeves include at least a continuous or substantially continuous layer of the photopolymerizable composition on a cylindrical support. Plate-on-sleeves include a flat photosensitive element mounted onto a cylindrical support. Development of cylindrical photosensitive printing elements having different diameters can be difficult, time consuming, and expensive. However, an apparatus and process for thermal development of cylindrical photosensitive printing elements is disclosed in the United States Patent Application Publication 2006/0104675 (EP1657593), which overcomes these problems. The process treats a photosensitive element having a cylindrical support and a composition layer adjacent the support opposite an interior surface of the support, the composition layer capable of being partially liquefied. During thermal processing, the cylindrically-shaped photosensitive printing element is held between a first supporting means and a second supporting means, and a hot roll is brought adjacent the first supporting means to treat an exterior surface of the photosensitive element opposite the support to form a relief surface in the element. The cylindrical photosensitive element is not fully supported during thermal development; and is only partially supported by the first support means and the second support means of the apparatus. The cylindrical photosensitive element is not firmly fixed on a supporting means, but it is processed in a so-called "loose-fit" mode. In loose-fit mode, the cylindrical photosensitive element is not fully contacted or supported by the supporting means; and only a part or parts of the interior surface are in contact with or supported by the supporting means. A nip is formed between the hot roll and the supporting means.

In order for easy mounting of cylindrically-shaped printing elements of various sizes into the apparatus, one end of the support means adjacent the hot roll is secured and cantilevered from a side or subframe of the apparatus so that the printing element can be loaded and unloaded from the opposite end. Although U. S. Publication No. 2006/0104675 indicates that the opposite end of the support means decouples and couples from a fastener on the subframe, no description is provided of the fastener. The U.S. publication also indicates that it is desirable to apply a uniform or substantially uniform pressure at the nip across the width (i.e., axial length) of the element during processing. Pressure is applied to force the absorbent material into intimate contact with the element, and to enhance removal of the unirradiated composition from the element by the absorbent material.

However, during thermal development a problem can arise in that the supporting means and/or the hot roll can deflect or bend upon contact of the element to the absorbent material at the nip. The application of pressure to force the absorbent material into intimate contact with the element can influence the bending or deflection exhibited by the supporting means and/or the hot roll. Deflection of the support means and/or the hot roll can be of such a degree that it results in non-uniformity in the pressure applied along an axial length of the element. In some instances, the first supporting means and the hot roll will bend such that a profile of the nip pressure across the width of the printing element results with higher pressure at both ends and lower pressure in the middle. It is desirable to assure pressure uniformity across the nip since non-uniform application of pressure can contribute to the resulting relief structure of the printing form having non-uniform relief depth.

Therefore, there is a need to overcome the problems of related art and to improve existing apparatuses for treating cylindrically-shaped elements, especially apparatuses for treating by thermal development of cylindrically-shaped printing elements. In particular there is a need for a solution that allows for the distribution of contact pressure on the cylindrically-shaped printing element at the nip between the support means and the hot roll during treating. There is a need to avoid differences in pressure at the nip across the width of the processed cylindrically-shaped and to create or maintain a uniform pressure profile to assure desired uniformity of relief depth the resulting printing form. There is a need for a solution to compensate for the deflection or bending of one or more of the opposing structures that form the nip with the element in between upon pressure contact. The solution should minimize deflection or bending of one or more of the opposing structures supporting the element during treatment, particularly when at least one of the opposing structures is cantilevered to allow the element access to the apparatus for treatment. Additionally, the apparatus should have access on one side to have the capability for easily or automatically mounting and demounting of cylindrically-shaped elements of various sizes.

### SUMMARY OF THE INVENTION

The invention provides for an apparatus for treating a cylindrically-shaped element that includes means for supporting the element by contacting an interior surface of the element, the supporting means having an axial length; and means for providing a treatment medium adjacent an exterior surface of the element opposite the interior surface, the providing means having an axial length adapted to form a contact nip between the treatment medium and the exterior surface along the axial length of the supporting means. The apparatus also includes clamping means for biasing the supporting means to a preset position at one end thereof and adapted to open and close around the supporting means wherein the clamping means maintains the axial length of the supporting means rigid in its preset position parallel to the axial length of the providing means or wherein the clamping means maintains the supporting means in a preset position that is a (pre)bent position along the axial length thereof; or clamping means for biasing the means for providing to a preset position at one end thereof and adapted to open and close around the providing means wherein the clamping means maintains the axial length of the providing means rigid in its preset position parallel to the axial length of the supporting means, or wherein the clamping means maintains the providing means in a preset position that is a (pre)bent position along the axial length thereof.

In accordance with another aspect of the invention there is provided a process for treating a cylindrically-shaped element as defined in claims 8 or 9 that includes supporting the element by contacting an interior surface of the element with a support member having an axial length; providing a treatment medium adjacent an exterior surface of the element opposite the interior surface with a contact member having an axial length adapted to form a contact nip between the treatment medium and the exterior surface along the axial length of the support member; and, clamping to bias the support member to a preset position at one end thereof and adapted to open and close around the support member, or, clamping to bias the contact member to a preset position at one end thereof and adapted to open and close around the contact member.

### BRIEF DESCRIPTION OF THE DRAWINGS

Figure 1 is a schematic front view of one embodiment of an apparatus for treating a cylindrically-shaped element showing one embodiment of a clamping means capable of biasing a supporting means to a preset position.
Figure 2 is a schematic side view of one embodiment of the clamping means in which the clamping means is opened and holding an end of the supporting means.
Figure 3 is a schematic side view of one embodiment of the clamping means in which the clamping means is closed and capable of biasing the supporting means to the preset position.

### DETAILED DESCRIPTION OF THE PREFERRED EMBODIMENTS

Throughout the following detailed description, similar reference characters refer to similar elements in all figures of the drawings.

The present invention is directed to an apparatus and process for treating a cylindrically-shaped element. In one embodiment the cylindrically-shaped element includes a photosensitive layer, and the apparatus and process is useful for treating the cylindrically-shaped photosensitive element by thermally developing the element to create a relief structure suitable for printing, such as a flexographic printing form or a letterpress printing form. The apparatus is capable of heating the photosensitive element having a layer of composition capable of being partially liquefied to a temperature sufficient to melt or soften or liquefy at least a portion of the layer for any purpose. In another embodiment, the cylindrically-shaped element is a cylindrical support, and the apparatus and process is useful for treating the cylindrically-shaped element by forming a layer or modifying an existing layer on an exterior surface of the support to create a cylindrically-shaped photosensitive form. The apparatus is capable of forming the layer of a photosensitive composition or other functional layer on the exterior surface of the support by suitable means including, but not limited to, laminating, extruding, calendering, and coating, to generate a cylindrically-shaped photosensitive form in an uncured or raw state. The uncured cylindrically-shaped photosensitive form can then be manipulated by any means, such as exposing and developing, to form a printing form having a relief surface. The cylindrically-shaped element may also be referred to herein as the cylindrical element, or simply the element. The cylindrically-shaped element is tubular, i.e., a hollow elongated cylinder. The cylindrically-shaped element has an axial length taken along a longitudinal axis running through the hollow of the element. The axial length of the cylindrically-shaped element may also be referred to herein as a width of the element. The cylindrical element has an interior circumference that is the perimeter (length) of the interior surface.

In one embodiment of the present apparatus, the cylindrically-shaped element can be mounted onto a support member of a supporting means such that the interior surface of the cylindrical element is fully contacted or supported, or substantially fully contacted or supported by the support member. In this embodiment, the support member is cylindrical and has a perimeter of the outer surface that is the same as or substantially the same as the interior circumference of the cylindrical element. The cylindrical element can be mounted directly onto the support member, or onto an adapter that is mounted onto the support member. To facilitate axial movement of the cylindrical element on the support member during mounting, air can be supplied to the outer surface of the support member and/or the adapter to allow the element to expand sufficiently to slide into position and create a suitable fit, such as an interference fit, when the air is off. Alternatively, the cylindrical element can first be slip fit mounted onto an adapter sleeve, and the adapter sleeve with the element are mounted onto the support member with the use of the air supplied to the outer surface of the support member. In this instance the first part of the interior surface of the cylindrical element is the entire or substantially the entire interior surface of the cylindrical element.

In another embodiment of the present apparatus, the cylindrically-shaped element is not firmly fixed on a supporting cylinder, such as a drum or adapter, during treating, but it is processed in a so-called "loose-fit" mode. In loose-fit mode, the interior surface of the cylindrical element is not fully contacted or supported by the support member; and only a part or parts of the interior surface are in contact with or supported by the supporting means. In one embodiment of loose-fit mode, one part of the interior surface circumference of the cylindrical element is contacted by or supported with the supporting means, such that the element has one part of the interior surface that is unsupported. In another embodiment of loose-fit mode, two or more parts of the interior surface circumference of the cylindrical element are contacted by or supported between a first and a second supporting means, such that the element resides about the first and second supporting means in a band-like fashion. The cylindrical element has one or more parts of the interior surface, between the supported parts, which are unsupported. The loose-fit mode provides an easy way to process cylindrical elements having different diameters (that is, interior circumferences) on the same apparatus without the need for a specific support cylinder, i.e., drum, for each diameter. This loose fit mode is particularly useful for thermally treating of cylindrical photosensitive elements in which the cylindrical support is a flexible sleeve and includes a continuous photopolymerizable layer on the sleeve. A suitable apparatus for thermal development of cylindrical printing elements in the loose fit mode is described for example in the United States Patent Application Pub. No. 2006/0104675 (EP1657593). It should be understood that the means for supporting the element in the apparatus of the present invention can be the first supporting means and/or the second supporting means of the apparatus as disclosed in U. S. Publication No. 2006/0104675 (EP1657593).

The apparatus and process of the present invention includes means for supporting the element by contacting a first part of an interior surface of the element, the supporting means having an axial length; means for providing a treatment medium adjacent an exterior surface of the element opposite the interior surface, the providing means having an axial length adapted to form a contact nip between the treatment medium and the exterior surface of the element along the axial length of the supporting means; and clamping means for the supporting means, and/or clamping means for the providing means. In one embodiment, the clamping means biases the supporting means to a preset position at one end thereof, and is adapted to open and close around the supporting means. In another embodiment, the clamping means biases the providing means to a preset position at one end thereof, and is adapted to open and close around the providing means.

The means for supporting supports the cylindrically-shaped element during treatment of the element in the apparatus. The means for supporting the cylindrical element supports a first part of the interior surface of the element and counters the load upon pressure contact with an opposing member, i.e., the means for providing the treatment medium, such as a contact member, during treating. The supporting means includes an outer surface that contacts the first part or segment of the interior surface of the element. In some embodiments the outer surface of the supporting means has an arcuate shape. The supporting means includes a support member that is not limited and can be, for example, a drum, a roller, a mandrel, and a platform. The supporting means, including the support member, has an axial length and a first end at which the cylindrical element is loaded and unloaded, and a second end that is coupled to a drive which rotates the support member during treating. Bearings are mounted on a shaft at each of the first and second ends of the supporting means to allow the supporting means to rotate during treating of the cylindrical element. Since at least the first end of the supporting means is engaged by the clamping means, the bearings are positioned on the first end of the shaft to correspond with each of the clamp fixtures of the clamping means. Bearings suitable for use on the shaft are not limited. In some embodiments, the bearings may include self-aligning (i.e., spherical) interior features to allow for a non-straight, i.e., bent, profile of the axial length of the supply means under load.

In one embodiment the support member of the supporting means is a roller mounted for rotation on a sub-frame of the apparatus, in which one end of the roller is securely held on the sub-frame and connected to a drive motor to cause the roller to rotate. In another embodiment the support member of the supporting means is a roller mounted for rotation on a sub-frame of the apparatus, in which one end of the roller is securely held by a second clamping means and connected to a drive motor to cause the roller to rotate. The roller can cantilever from the secured end for easy loading and unloading of the cylindrical element. The other end of the roller opposite the secured end engages with the clamping means.

Optionally, an adapter sleeve can be mounted onto the support member, e.g., the roller, in order to accomplish a greater maximum repeat length compared to the roller alone. The adapter sleeve can provide an alternative surface for the roller to aid in the development process. The adapter sleeve also can provide a resilient or compressible surface that assists in relief formation in the photosensitive element. In one embodiment, the roller is an air-shaft having radial passages that supply air to the outer surface of the roller. The air supplied to the outer surface facilitates movement of the optional adapter sleeve axially along and rotationally about the roller. The apparatus can include a pneumatic system that in one embodiment is connected typically to an end of the air-shaft to supply the air from a pressurized air source or generator to a cavity in the roller and through the passages to the outer surface. It is well within the skill of the art to contemplate alternate embodiments of supplying air to the outer surface. The optional adapter sleeve is mounted onto the air-shaft the same way or similar to the mounting of a printing sleeve or a bridge sleeve onto a printing cylinder. The combination of the air shaft with the adapter sleeve may be referred to as a format cylinder, herein.

Optionally, the present apparatus may include a second supporting means that supports a second part of the interior surface of the element different from the first part of the interior surface of the cylindrically-shaped element. The second supporting means can be used to support and/or tension the element during treating. The optional second supporting means includes an outer surface that contacts the second part of the interior surface. In some embodiments, the outer surface of the second supporting means has an arcuate shape, and can be treated or coated with an antifriction material, such as Teflon^{®} fluorinated polymers. The second supporting means is not limited and can include, for example, a drum, a roller, a mandrel, and a platform.

The present invention can be useful in the treating apparatus of U.S. Pub. No. 2006/0104675 which includes a first supporting means and a second supporting means that supports a second part of the interior surface of the cylindrically-shaped element different from the first part. The cylindrical element is partially supported by both the first supporting means and the second supporting means. The supporting means of the present invention can be the first supporting means or the second supporting means as disclosed in U.S. Publication No. 2006/0104675. Some embodiments of the present apparatus will include both the first supporting means and the second supporting means as disclosed in U.S. Pub. No. 2006/0104675, wherein the supporting means of present invention is the first supporting means of U.S. Pub. No. 2006/0104675.

The means for providing a treatment medium is located or can be located adjacent the supporting means (which is supporting the cylindrically-shaped element), so that the means for providing the treatment medium is adjacent the exterior surface of the cylindrically-shaped element opposite the interior surface. The apparatus can include a means for relative movement between the means for supporting the cylindrical element and the means for providing a treatment medium so as to locate the treatment medium adjacent the exterior surface of the cylindrical element. The means for relative movement may also be referred to as means for delivering (or means for supplying) the treatment medium and/or the cylindrical element. In some embodiments, the means for providing the treatment medium does not move relative to the supporting means. The cylindrical element on the supporting means can be moved by the delivery means toward the treatment medium. In an alternate embodiment, the means for providing the treatment medium can be moved toward the cylindrical element on the supporting means. It is well within the skill of those in the art to provide the apparatus with the means for delivering the cylindrical element and the treatment medium adjacent the one another. In one embodiment, the means for supporting and/or the means for providing the treatment medium is attached to beam/s or platform/s of carriage/s that move under the urging of one or more actuators. Suitable for use as one or more actuators can be air cylinders, or stepping motors, or servo motors. When the treatment medium and the exterior surface of the cylindrical element are brought adjacent to one another or into contact by the means for delivering, a nip is formed between the means for providing the treatment medium and the means for supplying.

The present apparatus also includes means for causing the cylindrical element and the treatment medium to come into contact at a pressure sufficient for the means for providing the treatment medium to carry out its function. In some embodiments, the pressure applied is sufficient for at least a portion of the liquefied material of the composition layer to be absorbed by the development medium. When the contact member is adjacent the supporting means, the nip is formed between the element and the contact member with the development medium between the element and contact member. Pressure is applied to force the development medium into intimate contact with the cylindrical element. In some embodiments, pressure is applied at the nip via the contact member of the means for providing the treatment medium. Pressure cylinders used as the means for delivering or means for supplying the development medium can also function as a means for pressing the contact member with the development medium into the element. Alternatively the means for delivering can function independent of the means for providing pressure. Pressure between about 0.70 kilograms per square centimeter and about 24 kilograms per square centimeter, preferably between about 2 kilograms per square centimeter and about 10 kilograms per square centimeter, in the nip area is adequate to enhance the absorption from the element surface to the development medium. In some other embodiments, the pressure applied is sufficient to apply or form a layer of a composition material onto the cylindrical support.

In some embodiments the means for providing a treatment medium includes a contact member that supplies the treatment medium to the cylindrical element. In this case, the treatment medium is a development medium which removes or blots or wicks away uncured material from the cylindrical element, upon thermal treating or thermal development. The contact member can be mounted for rotation in a sub-frame (not shown) of the apparatus. In one embodiment, the contact member is a roller carrying the development medium to the exterior surface of the element. The means for providing the treatment medium can also include embodiments in which the contact member has a non-rotating surface that supports the development medium in contact with the exterior surface of the element, as disclosed in U.S. Pub. No. 2006/0027113. The non-rotating surface of the contact member has advantages as it reduces the costs and simplifies the manufacture, operation, and maintenance of the apparatus as well as the method of using the apparatus. The contact member has a cross-sectional shape that is not limited, and can include, for example, elliptical, arcuate including convex and concave surfaces, parabolic, circular, semi-circular, wedge, triangular, rectangular, and other polygonal shapes. The shape of the contact member can be symmetrical or asymmetrical. The contact member may be solid or may include a cavity (not shown) to accommodate sources of heating the contact member or for circulating a heated fluid. The contact member can also have the cavity to minimize its weight and /or to minimize its thermal mass so as to have more rapid response to temperature changes or to minimize heat losses in undesired locations. The material/s of constructing the contact member is not limited, and should be resistant to thermal distortion at the temperatures associated with thermal processing.

In alternate embodiments, the means for providing a treatment medium encompasses means for applying the treatment medium to the exterior surface of the cylindrically-shaped element to form a layer of the medium on the element. In this case the treatment medium is a composition material that upon forming a layer upon the exterior surface provides additional, or different, or modified functionality to the cylindrically-shaped element. The means for applying includes, but is not limited to, laminating, extruding, calendering, and coating. The composition material may be photosensitive, i.e., reactive to actinic radiation, or non-photosensitive. In some embodiments, the means for applying the composition material generates a photosensitive layer on the cylindrical element (i.e., support) to create a cylindrically-shaped photosensitive form in an uncured or raw state, which can then be manipulated to create a printing form having a relief surface. In some other embodiments, the means for applying the composition material modifies an exterior surface of the cylindrically-shaped printing form by applying an additional or different composition material to an exterior surface of a cylindrically-shaped photosensitive layer on the cylindrical element.

In some embodiments, particularly relating to thermal development, the present apparatus further includes a means for treating the exterior surface of the cylindrical element by heating the element to a temperature suitable for the uncured portions of the composition layer to liquefy, i.e., melt or soften or flow. The uncured portions can be removed from the cured portions of the composition layer by any means including contacting with an absorbent material as described in U.S. 3,060,023; U.S. 3,264,103; U.S. 5,015,556; U.S. 5,175,072; U.S. 5,215,859; U.S. Patent 5,279,697; and U.S. 6,797,454. The treatment medium encompasses the absorbent material and the development medium. The contact member of the means for providing the treatment medium, may be heated and therefore also be considered a means for treating the element by heating. To the extent that the following treating means could result in nip contact of opposing structures that may have nonuniform pressure profile, the present invention also encompasses alternate means for treating the cylindrical element which remove uncured portions of the composition layer with an air or liquid stream under pressure as described in U.S. Pub. No. 2004/0048199 A1, and by vacuum as described in Japanese publication 53-008655.

In one embodiment, the present invention includes the clamping means for engaging the supporting means at one end thereof and for biasing the supporting means to a preset position. The clamping means compensates for deflection or bending of the support means that can occur upon load or pressure contact with the opposing contact member which results in non uniform pressure at the nip. The clamping means engages and biases the supporting means so that uniform or substantially uniform pressure is maintained along a contact nip on the cylindrically-shaped element between the opposing structures that form the nip, i.e., between the support member and the contact member. The clamping means engages the supporting means since the clamping means is adapted to close about one end of the supporting means. When engaging one end of the support means, the clamping means is capable of biasing the supporting means due to one or more of the features of the clamping means. When engaging one end of the support means, the clamping means is capable of biasing the supporting means due also in part to the opposite end of the support means being held securely. The clamping means not only engages at least one end of the supporting means so that the cylindrical element is appropriately supported on the supporting means, but also the clamping means retains at least one end of the supporting means in order to provide a sufficient force that biases the supporting means to the preset position. The preset position of the supporting means is a position of the axial length of the supporting means that is set or established prior to (pressure) contact by the opposing contact member. In some embodiments, the apparatus can include clamping means on only one end of the supporting means. In other embodiments, the apparatus can include a clamping means at each end of the supporting means, but only one of the clamping means need be adapted to open and close.

The clamping means provides improvement in the uniformity of the pressure profile at the nip over prior art embodiments in which both ends of the support means are fixed or securely fastened in the apparatus. The clamping means not only provides uniform or substantially uniform pressure on the cylindrical element such that there is only small, or little, or no differences in pressure along the axial length at the nip between the support member and the contact member, i.e., in the pressure profile, but also provides the capability to easily load and unload the cylindrical element to/from the apparatus. In some embodiments, the pressure profile can be considered uniform or substantially uniform when the axial length of the support member is parallel or substantially parallel to the axial length of the opposing contact member at the nip.

The clamping means is capable of maintaining the axial length of supporting means rigid or substantially rigid in its preset position upon pressing contact with the opposing structure, and thereby limit the degree of deflection that could occur on the supporting means where it is not for the presence of the clamping means. In some embodiments, the clamping means maintains the supporting means in a preset position that is straight from end to end, such that the axial length of the support means is linear or is not bowed or bent. In this case, the clamping means is capable of maintaining the preset position of the supporting means, such that the axial length of the supporting means does not or only slightly bows or bends upon pressing contact with the opposing contact member. Even though the axial length of the supporting means may slightly bow or deflect, the deflection of the supporting means with the clamping means is still less than if the clamping means was not present, and provides an improvement in the uniformity of the pressure profile in the nip on the cylindrical element. In other embodiments, the clamping means maintains the supporting means in a preset position that is a (pre)bent position from end to end, such that the axial length of the supporting means is bent or bowed. In some cases of this other embodiment, the clamping means is capable of maintaining or substantially maintaining the prebent position of the supporting means upon pressing contact with the opposing contact member. That is upon contact, the support member may retain its prebent position, or may become slightly less bent than its prebent position, and the axial length of the contact member conforms to the prebent position of the support member. In some cases of this other embodiment, the clamping means allows the supporting means to change from its prebent position so the axial length of the supporting means is no longer bent or bowed upon pressing contact with the opposing contact member. That is upon contact, the axial position of the support member changes to conform to the position of the axial length of the contact member. In all the embodiments of the preset position of the supporting means described herein, the clamping means biases the supporting means such that the pressure profile is uniform or substantially uniform in the nip on the cylindrical element upon contact with the opposing structure.

The clamping means includes a clamp assembly having at least two separate clamp fixtures. In most embodiments, the clamp assembly includes two clamp fixtures; a first clamp fixture and a second clamp fixture. In some embodiments, the clamping means is capable of biasing the supporting means to the preset position by separating the clamp fixtures to position the first clamp fixture at a distance from the second clamp fixture. Primarily, this embodiment aids in increasing the rigidity of the support means, and so minimizes deflection or excess bowing of the support means. In other embodiments, the clamping means is capable of biasing the supporting means to the preset position by shimming one of the clamp fixtures to provide a difference in a height at which the shaft of the support member resides from the one clamp fixture to the other clamp fixture. Primarily this embodiment aids in maintaining conformance along the axial length of the opposing structures. Either embodiment can provide benefit to maintain pressure uniformity along the axial length of the nip. Some embodiments use a combination of shimming and separated positioning of the two clamp fixtures to sufficiently bias the supporting means, and thereby maintain pressure uniformity along the axial length of the nip. The distance and/or the shim height between the separate clamp fixtures of the clamp assembly is chosen based on various factors including, but not limited to, the stiffness of the support member, the force necessary to maintain the support member to the preset position, the space between the bearings, the overall length of the shaft, as is well known to those skilled in the art.

The clamping means is adapted to open and close around a first end of the supporting means, to allow for easy mounting and the exchange of the cylindrically-shaped element from one side of the apparatus. Each clamp fixture of the clamp assembly includes an upper bracket and a lower bracket connected to each other at a first end that is adapted to separate and mate the upper bracket and the lower bracket in a hinge-like manner. During loading and unloading of the cylindrical element, the upper bracket and the lower bracket are separated from each other, and the clamp fixture is in the open position. During operations on the cylindrical element, i.e., treating, providing of the treatment medium, the upper bracket and the lower bracket are mated together, and the clamp fixture is in the closed position. Each of the upper and the lower brackets has a mating side that come into contact with each other when the clamp fixture is in the closed position. The mating side of each of the upper bracket and the lower bracket includes a semi-cylindrical recess that forms a passage for engaging the shaft or end of the supporting means when the upper bracket and the lower bracket are mated. Each of the bearings on the end of the supporting means is positioned on the shaft to mate with the passage in each of the clamp fixtures of the clamping means. The passage created by the recesses is sized to fit sufficiently around an outer race of the bearing. Each clamp fixture also includes a means for locking the upper bracket and the lower bracket together at the end opposite the hinge end. The means for locking the brackets securely captures or holds the shaft or end of the means for supporting in the clamp fixture to aid in biasing the support means in the preset position.

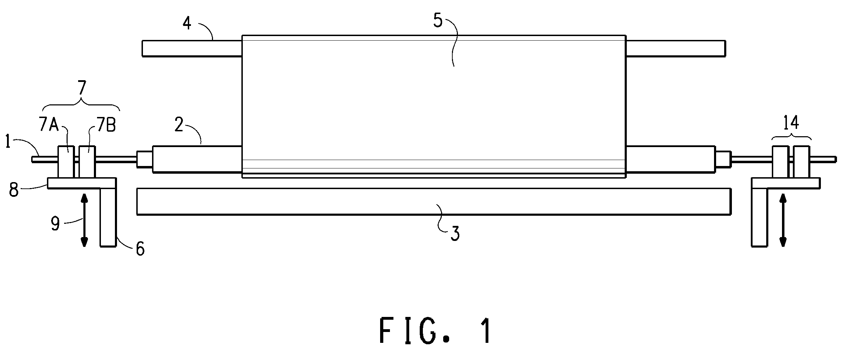

In one embodiment for shimming of the clamping means, the first clamp and the second clamp of the clamp assembly can be positioned in relation to each other to provide a difference in the height of the recess for each of the clamp fixtures on which the shaft of the supporting means resides. The recess of the lower bracket of the first clamp of the clamp assembly (i.e., the outermost clamp fixture 7A in Figure 1) has a height, h1, from a top side of the platform to a point of the recess that is closest to the platform (i.e., lowermost portion of the recess). The recess of the lower bracket of the second clamp of the clamp assembly (i.e., the inner clamp fixture 7B in Figure 1) has a height, h2, from the top side of the platform to a point of the recess that is closest to the platform, and that is different from the height h1 of the recess for the first clamp fixture. In this embodiment, the height h1 of the recess of the first clamp fixture is greater than the height h2 of the recess of the second clamp fixture. In other embodiments, the height h1 of the recess of the first clamp fixture is less than the height h2 of the recess of the second clamp fixture. The difference between h1 and h2 depends on the desired degree of prebending. In some embodiments, the difference between the height h1 of the first clamp fixture and the height h2 of the second clamp fixture can be, for example, in the range of 50 µm to 1000 µm In some embodiments, the difference between the height h1 and the height h2 can be between 100 and 500 µm. The difference in height between h1 and h2 can be achieved, for example, by positioning the lower bracket of the second clamp fixture on the platform lower than the lower bracket of the first clamp, or by the shimming the lower bracket of the first clamp.

Although the clamping means is described relative to the means for supporting (e.g., the format cylinder), it is contemplated that the clamping means can also be employed with the means for providing the treatment medium. As such, in an alternate embodiment the present invention includes the clamping means for engaging the providing means at one end thereof and for biasing the providing means to a preset position. The clamping means associated with the means for providing the treatment medium would be the same or substantially the same in design and function as the clamping means described herein for the supporting means. Similarly, the apparatus can include the clamping means on one or both ends of the means for providing the treatment medium. Clamping means on the means for providing the treatment medium would engage and bias the providing means to a preset position at one end thereof. It is also contemplated that the apparatus can have both the means for supporting and the means for providing the treatment medium with their own clamping means that can be at one or both ends of the opposing members.

Optionally, the apparatus may include a means for buttressing the means for providing the treatment medium and/or the supporting means. The means for buttressing can include one or more rollers positioned on a backside, i.e., a side opposite the nip, of the contact member and /or the support member. In several embodiments buttressing of the support member can be problematic particularly in situations when the cylindrical element is fitted to the support member, but is contemplated as a possible alternative embodiment. In most embodiments, the optional means for buttressing is applied to the backside of the contact member. The one or more rollers may have the same or different axial length as the axial length of the contact member. The means for buttressing can aid in compensating for the deflection or bending that can occur in the contact member upon load or pressure contact with the opposing member (i.e., support member), and thereby assist the clamping means in providing uniform pressure profile at the nip. In one embodiment of the means for buttressing the contact member, buttressing means includes a pair of heat-resistant rollers shorter than the axial length of the hot roller positioned about midway on the length of the hot roller. The heat-resistant rollers can be supported on a cross-member of the frame and can include a mechanism to adjust the position or height of the heat-resistant rollers relative to the hot roller.

Figure 1 shows one embodiment of an apparatus for treating a cylindrically-shaped element 5 in the loose-fit mode, in which the element includes a photosensitive layer, and the apparatus is useful for treating the cylindrically-shaped photosensitive element by thermally developing the element to create printing form having a relief structure suitable for printing. The apparatus includes one embodiment of a clamping means or clamping assembly 7 for biasing a supporting means to a preset position at a first end of the supporting means, and adapted for engaging the first end of the supporting means to open and close. The apparatus includes a first means for supporting 1 the cylindrical element 5 that contacts a first part of the cylindrical support of the element 5, a second means for supporting 4 the element that contacts a second part of the cylindrical support of the cylindrical element 5 different from the first part, and a means for providing 3 a treatment medium to an exterior surface of the cylindrical element. The first means for supporting 1 includes a roller that is an air shaft having radial passages for supplying air to its outer circumferential surface for mounting an adapter sleeve 2. The first means for supporting 1 may also be referred to as the format cylinder or the support member. The format cylinder 1 has a first end and a second end. The second end, located on a drive side of the apparatus, is coupled to a drive (not shown) for rotating the format cylinder. The format cylinder 1 cantilevers from the second end so that the cylindrical element 5 can be loaded and unloaded from the first end of the format cylinder 1.

The second means for supporting 4 includes a platform member having an outer surface with an arcuate shape that contacts the second part of the cylindrical element 5, which may be referred to as an arc or arc member 4. The arc member is movable to account for supporting cylindrical elements of various repeat lengths. The means for providing 3 the treatment medium is means for treating the exterior surface of the element 5 with a heated roll 3 that carries a continuous web of a development medium (not shown) as the treatment medium. The clamp assembly 7 includes two clamp fixtures 7A, 7B which are mounted on a platform 8 supported by a carriage 6. The platform 8 is connected to the carriage so that the platform can be moved vertically (up and down), as indicated by arrow 9, to raise and lower the clamp assembly 7. The carriage 6 can include one or more base members (not shown), which can be formed of the carriage and/or coupled to the carriage, for holding or attachment of one or more structures (such as the means for locking and/or the means for moving) of the clamp assembly 7. The vertical movement allows for the cylindrical element to be positioned for loading/unloading, and optionally can be used to tension the cylindrical element between the first supporting means 1 and the second supporting means 4. The movement of the platform 8 can be driven, e.g. by a motor, by a pneumatic or by an hydraulic system.

The apparatus further includes a second clamping means 14 at the second end of the format cylinder 1. The clamp assembly 14 secures the format cylinder 1 at the drive side of the apparatus. The clamp assembly 14 includes two clamp fixtures which are identical or nearly identical to the clamp fixtures 7A, 7B of clamp assembly 7 except that the brackets of the clamp fixtures of the clamp assembly 14 are fixed together with screws so that the clamp fixtures do not open or close. Since the cylindrical element 5 is mounted from the first end of the format cylinder 1, there is no need for the clamp fixtures to open or close on the drive side of the format cylinder 1. Clamping means 14 can be mounted to a movable platform of a carriage analogous to the mounting of the clamping means 7 onto platform 8. Both the platform 8 of the clamp assembly 7 and the platform of the clamp assembly 14 should synchronously operate to move both ends of the format cylinder 1 at the same time to keep the format cylinder substantially horizontal. In most embodiments where the clamp assembly is biased by shimming, the shimming of the appropriate clamp fixtures at each end of the format cylinder should also be symmetrical to ensure the needed difference between height h1 and h2.

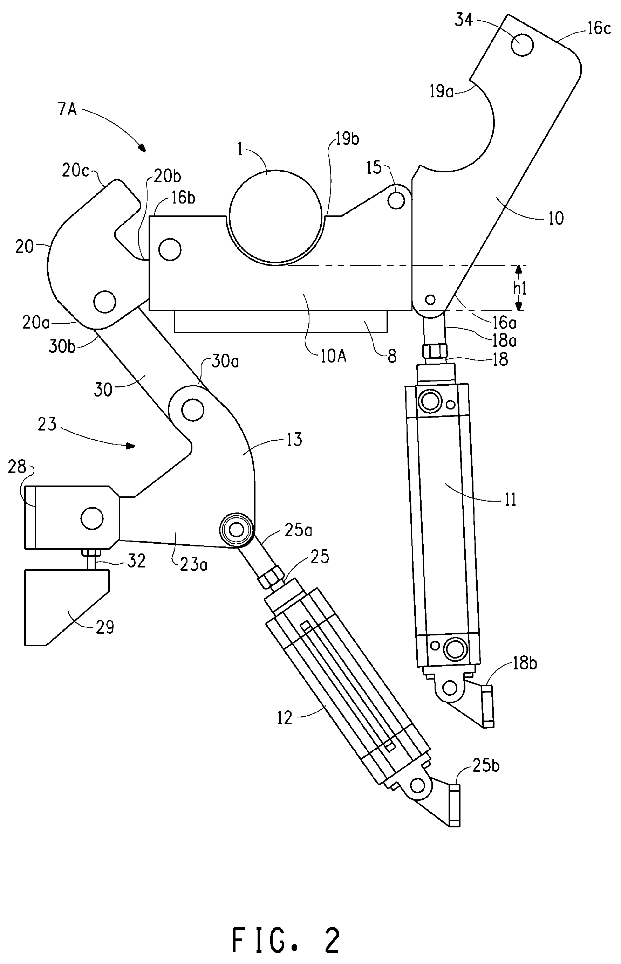

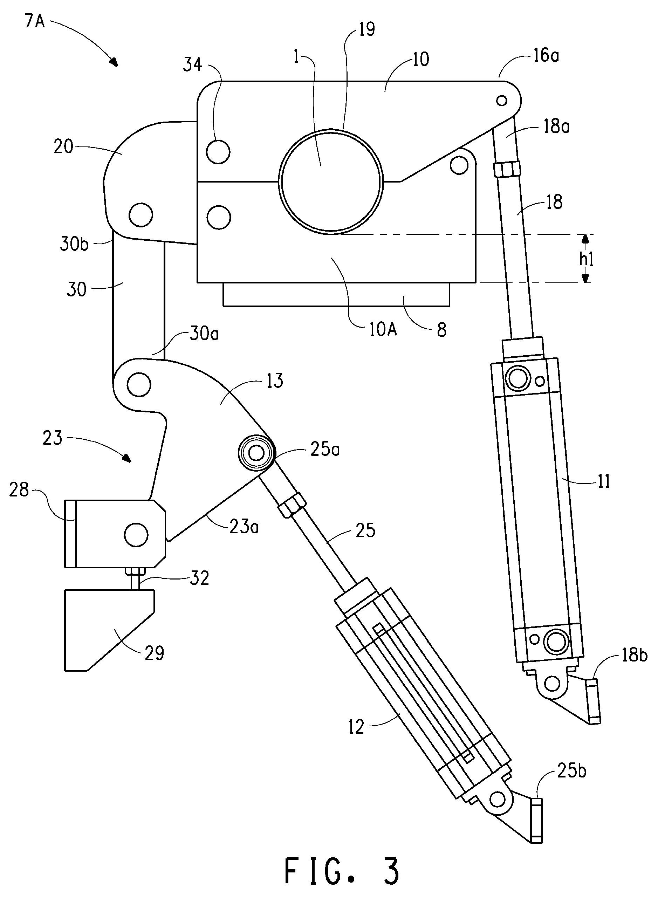

Referring to Figures 2 and 3, one of the clamp fixtures 7A of the clamp assembly 7 is shown in an open position and in a closed position, respectively. Each of the clamp fixtures in the clamp assemblies 7,14 is substantially the same and so will be described in reference to clamp fixture 7A. The clamp fixture 7A includes an upper bracket 10, a lower bracket 10A, a means for moving 11 the upper bracket 10, and a means for locking 13 the brackets 10,10A together. The upper bracket 10 and the lower bracket 10A connect to each other by a hinge 15 at a first end 16a. The hinge 15 is adapted to separate and mate the upper bracket10 and the lower bracket 10A. The operation of the clamp fixture 7A from the "close" to the "open" position and vice versa is determined by the means for moving 11 the upper bracket 10. The means for moving 11 has a rod 18 with first end 18a pivotally coupled to the first end 16a of the upper bracket 10, and a second end 18b secured by bolts to the carriage 6. The means for moving 11 is not limited, and can be for example, an actuating cylinder that can be operated by air, fluids, or gas. In most embodiments, the means for moving 11 is an air driven pneumatic cylinder. To open the clamp fixture 7A, the rod 18 of the means for moving 11 is retracted by the actuating cylinder, and the first end 16a of the upper bracket 10 pivots (clockwise in Figures 2 & 3) at the first end 18a of the rod 18, about the hinge 15. To close the clamp fixture 7A, the rod 18 of the means for moving 11 is extended by the actuating cylinder, and the first end 16a of the upper bracket 10 pivots (counterclockwise in Figures 2 & 3) at the first end 18a of the rod 18, about the hinge 15.

The clamp fixture 7A in the closed position is locked to securely hold the upper bracket 10 and the lower bracket 10A together by the means for locking 13. The clamp fixture 7A in the closed position also secures the end of the support means 1 that is positioned in the passage 19 formed by the recesses 19a, 19b in the mating sides of the upper bracket 10 and lower bracket 10A. As such, the means for locking 13 assures that the supporting means appropriately maintains its bias to the preset position upon load. One embodiment of the means for locking 13 is an assembly that includes a U-shaped latch 20, a three-part linkage 23, and a means for moving 12 the linkage 23 and the latch 20. The means for moving 12 the locking assembly 13 has a rod 25 with a first end 25a connected to the three-part linkage 23, and a second end 25b secured by bolts to the carriage 6. The means for moving 12 is similar to the moving means 11 and can be a linear actuating cylinder operated by air, fluids, or gas. The three-part linkage 23 includes a triangular-shaped link 23a in which a first apex of the link is connected to the first end 25a of the rod 25, a second apex of the link is pivotally coupled to a bracket 28, and a third apex of the link is pivotally coupled to a first end 30a of a lever 30. The bracket 28 is coupled to a block 29 that is mounted in a fixed position on the carriage 6. A means for adjusting the vertical position 32 of the bracket 28, which connects the bracket to the block 29, will accordingly alter the location of the pivot coupling, and thus a pivot point for this apex of the linkage 23a. The means for adjusting 32 is a fine adjustment for positioning the U-shaped latch 20 of the means for locking 13, and can serve as an adjustment to align the pivot point with the corresponding pivot point of the adjacent clamp fixture 7B. An end 30b opposite the first end of the lever 30 is pivotally coupled to a base portion 20a of the U-shaped latch 20. A first arm 20b of the U-shaped latch 20 is pivotally coupled to an end 16b of the lower bracket 10A opposite the hinge end 16a. An end 16c of the upper bracket 10 opposite the hinge end 16a includes a groove (not shown) and a pin 34 mounted transverse to the clamp fixture 7A such that a portion of the pin is revealed in the groove. The upper bracket 10 and the lower bracket 10A are locked together by first extending the rod 25 by the actuating cylinder of the means for moving 12, which causes the triangular-shaped link 23a and the lever 30 of the three-part linkage 23 to appropriately pivotally move to rotate the first arm 20b of the latch 20 about its connection to the end 16b of the lower bracket 10A. The rotation of the latch 20 moves at least a second arm 20c of the U-shaped latch within the groove so that the second arm is positioned above the pin 34, and thereby retains the upper bracket 10 against the lower bracket 10A. The upper bracket 10 and the lower bracket 10A are unlocked by first retracting the rod 25 by the actuating cylinder of the means for moving 12 which causes the triangular-shaped link 23a and the lever 30 of the three-part linkage 23 to appropriately pivotally move to rotate the first arm 20b of the latch 20 about its connection to the end 16b of the lower bracket 10A, so that the second arm 20c of the U-shaped latch 20 is moved out of the groove and no longer is positioned above the pin 34.

The means for locking 13 the clamping fixtures 7A, 7B is not limited to the embodiment shown, since one of ordinary skill in the art can contemplate alternate embodiments of the means for locking the clamp fixture.

The operation of the process for maintaining a uniform pressure along the contact nip will be explained relative to the embodiment shown in Figures 1 to 3. The process begins by moving the first supporting means 1 and/or the second supporting means 4 sufficiently close together so that the cylindrical element 5 will encompass both the first and second support means when being mounted. In most embodiments, the first and second support means are sufficiently close when the distance between diametrically opposite exterior surfaces of the first and second support means is less than an interior diameter of the element. In embodiments of the apparatus having only one support means, it may be useful but not necessary to move the support means into position for loading of the element. An operator manually mounts the element into the apparatus by placing the cylindrical element 5 about a first end of both the first support means 1 and second support means 4 so that the element encompasses both the support means, and then slides the element along the axial length of the support means. The apparatus could accommodate two or more photosensitive elements on the support means, provided that the sum of the widths (axial lengths) of all the elements is less than the axial length of the support means. The format cylinder 1 is cantilevered from the second end such that the first end of the format cylinder is unsupported. At this time, both clamp fixtures 7A and 7B of the clamping assembly 7 are open and the platform 8 is in a lowered position, so as not to interfere with the loading of the cylindrical element 5. The carriage 6 then moves to raise the platform 8 with the clamping assembly 7 until the recess 19b of each of the lower brackets 10A contacts each of the bearings mounted on the first end of the format cylinder 1. For each of the clamp fixtures 7A, 7B the means for moving 11 is actuated, extending the rod 18 and pivoting the upper bracket 10 about the hinge15, which closes the clamp fixture by mating the upper bracket 10 with the lower bracket 10A and captures the first end of the format cylinder 1 in the passage 19. Each of the clamp fixtures 7A,7B are locked as described above, by extending the rod 25 of the means for moving 12 causing the three-part linkage 23 to pivotally move and rotate the latch 20 to position the second arm 20c of the U-shaped latch above the pin 34 to hold the upper bracket 10 adjacent the lower bracket 10A.

In some embodiments, the passage 19 of one of the clamp fixtures has a height that is different from a height of the passage of the other clamp fixture of the clamp assembly. The height of the passage is measured from a lowermost portion of the recess to a plane in common between the two clamp fixtures 7A, 7B of the clamp assembly 7, such as a top side of the platform 8. The passage 19 of the clamp fixture 7A is at a height h1, and the passage of the clamp fixture 7B is at a height h2 (not shown). In this embodiment, the passage 19 of the outer clamp fixture 7A and the passage 19 of the inner clamp fixture 7B are aligned axially relative to a width between the hinge 15 and the end 16b of the lower bracket 10A of each fixture, but are axially offset vertically by the difference in height between h1 and h2. In some embodiments, the height h1 of clamp fixture 7A is greater than the height h2 of the second claim fixture 7B. The brackets of each of the double clamp fixtures of clamp assembly 14 are fixed together and securely hold the second end of the support member. Similar to clamp assembly 7, the passage for the outermost clamp fixture of the clamp assembly 14 is at a height greater than a height of the passage for the innermost clamp fixture of the clamp assembly 14. Upon locking the clamping assembly, the clamp fixtures engage the end of the support member and the differences in height h1 and h2 of each of the clamp fixtures of the clamp assemblies 7, 14 cause the support member to bias to a prebent position. For each clamp assembly 7, 14, the two clamp fixtures are separated from each other by a distance, which provides sufficient rigidity (i.e., increased resistance to deflection) to the support member to maintain or substantially maintain the axial length of the support member at the prebent position.

Relative motion between the hot roller 3 of the means for providing the treatment medium and the first supporting means 1 (and the second supporting means 4) forms the nip where the cylindrical element 5 contacts the development medium. The contact pressure between the support member 1 and the hot roller 3 at the nip on the cylindrical element 5, cause the hot roller opposing the support member 1 to conform to the preset shape of the support member and thereby provide uniform or substantially uniform pressure in the nip experienced by the cylindrical element during treating. After treatment is completed, the process is reversed in which the clamp fixtures 7A,7B are unlocked and opened as described above. The carriage 6 moves the platform 8 with the clamp assembly 7 downward to allow unloading of the cylindrical element 5 from the apparatus.

### Treading by Thermal Development

One embodiment of the means for providing a treatment medium is treating a photosensitive cylindrical element by thermal development. Following imagewise exposure to actinic radiation a cylindrical photosensitive element as the cylindrical element is thermally treated to remove unpolymerized areas in the photopolymerizable layer and thereby form a relief image. The thermal treating step removes at least the photopolymerizable layer in the areas that were not exposed to actinic radiation, i.e., the unexposed areas or uncured areas, of the photopolymerizable layer. The composition layer of the photosensitive element is heated to a temperature sufficient to cause a portion of the layer, i.e., unirradiated area, or an uncured or unpolymerized portion, to soften, melt, flow, or liquefy. The polymerized areas of the photopolymerizable layer have a higher melting temperature than the unpolymerized areas and therefore do not melt, soften, or flow at the thermal development temperatures. Thermal development of photosensitive elements to form flexographic printing plates is described, for example, by Martens in U.S. Patents 5,015,556; 5,175,072; 5,215,859; and by Wang et al. in WO 98/13730.

The photosensitive element is heated to a surface temperature above about 40°C, preferably from about 40°C to about 230°C (104-446°F) in order to effect softening, melting, or flowing of the uncured portions of the composition layer. One or more additional layers disposed above the composition layer may soften or melt or flow and be removed as well by the development medium.

The exterior surface of the photosensitive element can be heated by one or more sources in a thermal development apparatus. Independently or in any combination, the sources for heating are capable of heating the exterior surface of the photosensitive element to a temperature sufficient to cause a portion of the composition layer to at least partially liquefy. Means for heating the at least one photosensitive layer (and additional layer/s if present) can be by conduction, convection, radiation or other heating methods that heat the layer to a temperature sufficient to effect melting of the uncured portions but not so high as to effect distortion of the cured portions of the layer. The method for heating each of the sources are not limited and can include, for example, an electrical core heater, electric heating blanket, steam, oil, hot air, and other heating sources that can provide a temperature sufficient to maintain or elevate the temperature of the exterior surface to melt a portion of the composition layer. In one embodiment, heating of the exterior surface of the photosensitive element is with a radiant heater and a source for heating the support member.

In one embodiment the heating source is associated with the supply member that heats the exterior surface of the composition layer while supplying the development medium to the element. Heat is transferred by conduction from the supply member through the development medium to the exterior surface of the element upon contact, raising the temperature of the element and causing the uncured portions of the composition layer of the element to melt, soften, or flow to the development medium.

The processor may include another source for heating that is a focused radiant heater/s directed at the exterior surface of the photosensitive element. The radiant heater can apply all or a portion of the heat needed to the exterior surface of the composition layer, to elevate the temperature of the exterior surface of the composition layer sufficient to melt the unirradiated portion of the composition layer, causing a portion of the layer to liquefy. The heater can include one or a plurality of tubular infrared heating bulb/s mounted in end supports that also provide electrical connections to the bulb/s. The heater can also include a reflector adjacent to the bulb/s that acts to focus and direct the infrared radiation toward the exterior surface of the element.

Another heating source is associated with the base member that supports the photosensitive element during thermal development. The base member may be equipped with a heater, such as a blanket heater. which is provided to keep the photosensitive element at a stable starting temperature independent of the surrounding environment. The base member may include means for controlling a temperature of the base member, which helps to manage the thermal conditions experienced by the photosensitive element. In particular the means for controlling the temperature can be used to maintain the temperature of the support side of the photosensitive element. The means for controlling the base member temperature can include means for heating, means for cooling, and a combination thereof. Any means of heating the base member is acceptable.

The thermal development process is conducted typically with more than one cycle of heating the element and contacting the element with the development medium in order to remove the uncured polymer to a suitable relief depth because uncured portions of the composition layer may only partially liquefy upon heating. In a preferred embodiment, treating also includes contacting an outermost surface of the element to an absorbent surface to remove by absorbing or wicking away the softened, melt, or flow portions. The thermal treating steps of heating the photosensitive element and contacting an outermost surface of the element with development medium can be done at the same time, or in sequence provided that the uncured portions of the photopolymerizable layer are still soft or in a melt state when contacted with the development medium. By maintaining more or less intimate contact of the development medium with the photopolymerizable layer that is molten in the uncured regions, a transfer of the uncured photosensitive material from the photopolymerizable layer to the development medium takes place. While still in the heated condition, the development medium is separated from the cured photopolymerizable layer in contact with the support layer to reveal the relief structure. A cycle of the steps of heating the photopolymerizable layer and contacting the molten (portions) layer with an absorbent material can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the development medium to the photopolymerizable layer (while the uncured portions are melt) may be maintained by pressing the layer and the development medium together.

The development medium is selected having a melt temperature exceeding the melt temperature of the uncured portions of the photopolymerizable layer and having good tear resistance at the same operating temperatures. Preferably, the selected material withstands the temperatures required to process the photosensitive element during heating. The development medium is selected from non-woven materials, paper stocks, fibrous woven material, open-celled foam materials, porous materials that contain more or less a substantial fraction of their included volume as void volume. The development medium can be in web or sheet form. The development medium should also possess a high absorbency for the molten elastomeric composition as measured by milligrams of elastomeric composition that can be absorbed per square centimeter of the development medium. Preferred is a non-woven web.

### Cylindrically-Shaped Element

The cylindrically-shaped element to be treated in the apparatus of the present invention has an association with a cylindrical shape or substantially cylindrical shape. Cylindrically-shaped element encompasses cylindrical elements having one or more photosensitive layers pre-existing on the element, and cylindrical elements without a photosensitive layer, such as a support or sleeve. In one embodiment, the cylindrically-shaped element may only be a support or a sleeve, and the apparatus prepares a cylindrical photosensitive element by treating the sleeve support to include one or more layers on the sleeve support. In another embodiment, the cylindrically-shaped element may be a cylindrical photosensitive element as described in the following embodiments, which undergoes thermal treatment to make a printing form having a relief surface. The support for the element itself may be cylindrical, or the element may be grouped with at least one other structure that is cylindrically shaped. Since in one embodiment the resulting printing form is ultimately mounted onto a printing cylinder, the shape of the support or structure is generally cylindrical. However, the element may not be cylindrical or may only be substantially cylindrically shaped while in operative engagement in the present apparatus and process or when not mounted onto the printing cylinder. The element may include a continuous, seamless or substantially seamless, photopolymerizable composition layer adjacent to or on the cylindrically-shaped support. The element can also encompass plate-on-sleeve system. Typically, plate-on-sleeve is a cylindrically-shaped element that includes at least the composition layer on a planar support, i.e., a plate, which is then mounted onto a cylindrically- shaped support. Ends of the plate may or may not meet or join when wrapped onto the sleeve. Plate-on-sleeve also includes an embodiment in which more than one plate, or portions of plates, are mounted onto a sleeve at various spaced locations. Also contemplated as the element is a photosensitive plate having at least one photopolymerizable composition layer preferably on a base support, which is formed into a cylinder by butt joining both edges. The plate edges can be joined by any method including, but not limited to, melt fusing, taping, stitching, clamping, stapling, taping, gluing, and sewing. In this embodiment the base support would become the cylindrical support. Any of the embodiments that include the photosensitive layer as described herein may be referred to as cylindrical printing elements or cylindrical printing forms. The cylindrical printing form has an interior surface having an interior diameter and an interior circumference (i.e., the perimeter of the interior surface). In one embodiment, the printing element has been image-wise exposed to actinic radiation thereby polymerizing the photosensitive composition layer in the exposed areas.

### Photosensitive Element

The photosensitive element used for preparing flexographic printing forms includes at least one layer of a photopolymerizable composition. The term "photosensitive" encompass any system in which the at least one photosensitive layer is capable of initiating a reaction or reactions, particularly photochemical reactions, upon response to actinic radiation. In some embodiments, the photosensitive element includes a support for the photopolymerizable layer. In some embodiments, the photopolymerizable layer is an elastomeric layer that includes a binder, at least one monomer, and a photoinitiator. In some embodiments, the photosensitive element includes a layer of an actinic radiation opaque material adjacent the photopolymerizable layer, opposite the support. In other embodiments, the photosensitive element includes an image of actinic radiation opaque material suitable for use as an in-situ mask adjacent the photopolymerizable layer.

Unless otherwise indicated, the term "photosensitive element" encompasses printing precursors capable of undergoing exposure to actinic radiation and treating to form a surface suitable for printing. Unless otherwise indicated, the "photosensitive element" and "printing form" includes elements or structures in any form which become suitable for printing or are suitable for printing, including, but not limited to, flat sheets, plates, seamless continuous forms, cylindrical forms, plates-on-sleeves, and plates-on-carriers. It is contemplated that printing form resulting from the photosensitive element has end-use printing applications for relief printing, such as flexographic and letterpress printing. Relief printing is a method of printing in which the printing form prints from an image area, where the image area of the printing form is raised and the non-image area is depressed.

The photosensitive element includes at least one layer of a photopolymerizable composition. As used herein, the term "photopolymerizable" is intended to encompass systems that are photopolymerizable, photocrosslinkable, or both. The photopolymerizable layer is a solid elastomeric layer formed of the composition comprising a binder, at least one monomer, and a photoinitiator. The photoinitiator has sensitivity to actinic radiation. Throughout this specification actinic light will include ultraviolet radiation and/or visible light. The solid layer of the photopolymerizable composition is treated with heat to form a relief suitable for flexographic printing.

The binder is not limited and can be a single polymer or mixture of polymers. In some embodiments, the binder is an elastomeric binder. In other embodiments, the binder becomes elastomeric upon exposure to actinic radiation. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. In some embodiments, the binder is an elastomeric block copolymer of an A-B-A type block copolymer, where A represents a non-elastomeric block, and B represents an elastomeric block.

The photopolymerizable composition contains at least one compound capable of addition polymerization that is compatible with the binder to the extent that a clear, non-cloudy photosensitive layer is produced. The at least one compound capable of addition polymerization may also be referred to as a monomer. Monomers that can be used in the photopolymerizable composition are well known in the art and include, but are not limited to, addition-polymerization ethylenically unsaturated compounds with at least one terminal ethylenic group. Monomers can be appropriately selected by one skilled in the art to provide elastomeric property to the photopolymerizable composition.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators may be used. Alternatively, the photoinitiator may be a mixture of compounds in which one of the compounds provides the free radicals when caused to do so by a sensitizer activated by radiation.

The thickness of the photopolymerizable layer can vary over a wide range depending upon the type of printing form desired. In some embodiments, the photosensitive layer can have a thickness from about 0.002 inch to about 0.250 inch or greater (about 0.051 mm to about 0.64 cm or greater). Typical thickness of the photopolymerizable layer is from about 0.010 inches to about 0.250 inches (about 0.025 cm to about 0.64 cm).

The photosensitive element may optionally include a support adjacent the layer of the photosensitive composition. The support may be cylindrically shaped itself, or as was explained above, for plates-on-sleeves may be planar and mounted onto a cylindrical support, or may be planar sheet of a photosensitive plate formed into a cylinder by securing the end edges together by any method. The support can be composed of any material or combination of materials that is conventionally used with photosensitive elements used to prepare printing forms. In some embodiments, the support is transparent to actinic radiation to accommodate "backflash" exposure through the support. Examples of suitable support materials include polymeric films such those formed by addition polymers and linear condensation polymers, transparent foams and fabrics, such as fiberglass. Under certain end-use conditions, metals such as aluminum, steel, and nickel, may also be used as a support, even though a metal support is not transparent to radiation. In some embodiments, the support is a polyester film. In one embodiment, the support is polyethylene terephthalate film. The support may be in sheet form or in cylindrical form, such as a sleeve. The sleeve can be formed of any material or combination of materials conventionally used in forming sleeves for printing. The sleeve can have a single layer, multi-layer, composite, or unitary structure. Sleeves can be made of polymeric films that are typically transparent to actinic radiation and thereby accommodate backflash exposure for building a floor in the cylindrical printing element. Multiple layered sleeves may include an adhesive layer or tape between the layers of flexible material, such as disclosed in U.S. Patent 5,301,610. The sleeve may also be made of non-transparent, actinic radiation blocking materials, such as nickel or glass epoxy. The sleeve may be composed of one or more layers of a resin composition, which can be the same or different, and have fillers and/or fibers incorporated therein. Materials suitable as the resin composition are not limited, examples of which include, epoxy resins; polystyrene and polyvinyl resins, such as polyvinyl chloride and polyvinyl acetate; phenolic resins; and aromatic amine-cured epoxy resins. The fibers used in the resin composition are not limited and can include, for example, glass fibers, aramid fibers, carbon fibers, metal fibers, and ceramic fibers. Fibers incorporated with the sleeve can include continuous, woven, and/or wound materials. The support formed of a resin composition reinforced with fiber is an example of a composite sleeve. In some embodiments, the support has a thickness from 0.002 to 0.050 inch (0.0051 to 0.127 cm). The sleeve can have a wall thickness from about 0.01 and about 6.35 mm or more. In some embodiments, the sleeve has a wall thickness between about 0.25 and 3 mm. In some embodiments, the sleeve has a wall thickness between about 10 to 80 mils (0.25 to 2.0 mm), and in other embodiments 10 to 40 mils (0.25 to 1.0 mm).

Optionally, the element includes an adhesive layer between the support and the photopolymerizable layer, or a surface of the support that is adjacent the photopolymerizable layer has an adhesion promoting surface to give strong adherence between the support and the photopolymerizable layer.

As is well known to those of ordinary skill in the art, the photosensitive element may include one or more additional layers on or adjacent the photosensitive layer, that is, on a side of the photopolymerizable layer opposite the support. These layers may include at least one thermally removable layer on the photopolymerizable layer, such as disclosed by Fan et al. in U.S. Patent 6,773,859 B2. Depending on desired use, the additional layers may be opaque or transparent to actinic radiation, and may have one or more functions for the photosensitive element. The additional layers include, but is not limited to, a release layer, an actinic radiation opaque layer, a barrier layer, infrared-sensitive layer, an actinic-radiation opaque layer, an adhesion modifying layer, a layer which alters the surface characteristics of the photosensitive element, and combinations thereof. It is well within the ordinary skill of those in the art to select and prepare additional layers on the photopolymerizable layer according to desired end-use. The one or more additional layers can be removable, in whole or in part, during treatment. One or more of the additional layers may cover or only partially cover the photosensitive composition layer.

The photosensitive element optionally includes a temporary cover sheet on top of the outermost layer of the photosensitive element. Cover sheets consist of flexible polymeric films, and typically are polyesters, preferably polyethylene terephthalate. The cover sheet may be unsubbed, or may be subcoated with a thin silicone layer.

Before thermal treatment, the photosensitive element is exposed to actinic radiation. Upon imagewise exposure, the radiation-exposed areas of the photopolymerizable layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps.

These radiation sources generally emit long-wave UV radiation between 31 0-400 nm. The exposure time may vary from a few seconds to minutes, depending upon the intensity and spectral energy distribution of the radiation, its distance from the photosensitive element, and the nature and amount of the photopolymerizable material. Imagewise exposure can be carried out by exposing the photosensitive element through an image-bearing mask. The mask can be a separate film, i.e., an image-bearing transparency or phototool, such as a silver halide film; or the photomask can be integrated with the photosensitive element by digital methods as is well known to those of ordinary skill in the art.

## Claims

1. An apparatus for treating a cylindrically-shaped element comprising:
means for supporting the element by contacting a first part of an interior surface of the element, the supporting means having an axial length;
means for providing a treatment medium adjacent an exterior surface of the element opposite the interior surface, the providing means having an axial length adapted to form a contact nip between the treatment medium and the exterior surface along the axial length of the supporting means;
**characterised in that** it further comprises
clamping means for biasing the supporting means to a preset position at one end thereof and adapted to open and close around the supporting means,
wherein the clamping means maintains the axial length of the supporting means rigid in its preset position parallel to the axial length of the providing means or wherein the clamping means maintains the supporting means in a preset position that is a (pre)bent position along the axial length thereof.

2. An apparatus for treating a cylindrically-shaped element comprising:
means for supporting the element by contacting a first part of an interior surface of the element, the supporting means having an axial length;
means for providing a treatment medium adjacent an exterior surface of the element opposite the interior surface, the providing means having an axial length adapted to form a contact nip between the treatment medium and the exterior surface along the axial length of the supporting means;
**characterised in that** it further comprises
clamping means for biasing the means for providing to a preset position at one end thereof and adapted to open and close around the providing means,
wherein the clamping means maintains the axial length of the providing means rigid in its preset position parallel to the axial length of the supporting means, or wherein the clamping means maintains the providing means in a preset position that is a (pre)bent position along the axial length thereof.

3. The apparatus of Claim 1 or Claim 2 wherein the clamping means comprises a clamp assembly of at least two clamp fixtures, which are separated from each other.

4. The apparatus of Claim 3 wherein at least one of the clamp fixtures comprise an upper bracket having a recess and a lower bracket having a recess, the upper bracket and the lower bracket adapted to mate and form a passage of the recesses to hold the supporting means.

5. The apparatus of Claim 3 wherein the clamp assembly comprises a first clamp fixture and a second clamp fixture on a platform, wherein the first clamp fixture comprises an upper bracket and a lower bracket having a passage at a height h1 from the platform; the second clamp fixture comprises an upper bracket and a lower bracket having a passage at a height h2 from the platform, and wherein h1 and h2 are different.

6. The apparatus of Claim 1 further comprising a second clamping means at a second end of the supporting means opposite the one end thereof.

7. The apparatus of Claim 1 wherein the supporting means is selected from the group consisting of a drum, a roller, a plurality of rollers, and a platform member.

8. A process for treating a cylindrically-shaped element, said process comprising:
supporting the element with a support member by contacting an interior surface of the element, the support member having an axial length;
providing a treatment medium adjacent an exterior surface of the element opposite the interior surface with a contact member having an axial length adapted to form a contact nip between the treatment medium and the exterior surface along the axial length of the contact member; and
clamping to bias the support member to a preset position at one end thereof and adapted to open and close around the support member
wherein the clamping means maintains the axial length of the support member rigid in its preset position parallel to the axial length of the contact member or wherein the clamping means is prebending the support member along the axial length thereof.

9. A process for treating a cylindrically-shaped element, said process comprising:
supporting the element with a support member by contacting an interior surface of the element, the support member having an axial length;
providing a treatment medium adjacent an exterior surface of the element opposite the interior surface with a contact member having an axial length adapted to form a contact nip between the treatment medium and the exterior surface along the axial length of the contact member; and
clamping to bias the contact member to a preset position at one end thereof and adapted to open and close around the contact member
wherein the clamping means maintains the axial length of the contact member rigid in its preset position parallel to the axial length of the support member or
wherein the clamping means is prebending the contact member along the axial length thereof.

## Patentansprüche

1. Vorrichtung zur Behandlung eines zylindrisch geformten Elementes, die aufweist:
ein Mittel für das Tragen des Elementes durch Kontaktieren eines ersten Teils einer inneren Fläche des Elementes, wobei das Mittel für das Tragen eine axiale Länge aufweist;
ein Mittel für das Bereitstellen eines Behandlungsmittels benachbart einer äußeren Fläche des Elementes entgegengesetzt der inneren Fläche, wobei das Mittel für das Bereitstellen eine axiale Länge aufweist, die ausgebildet ist, um einen Kontaktklemmpunkt zwischen dem Behandlungsmittel und der äußeren Fläche entlang der axialen Länge des Mittels für das Tragen zu bilden;
**dadurch gekennzeichnet, dass** sie außerdem aufweist:
ein Klemmmittel für das Vorspannen des Mittels für das Tragen in eine vorher eingestellte Position an einem Ende davon, und ausgebildet, um sich um das Mittel für das Tragen herum zu öffnen und zu schließen,
wobei das Klemmmittel die axiale Länge des Mittels für das Tragen in seiner vorher eingestellten Position parallel zur axialen Länge des Mittels zum Bereitstellen nicht verschiebbar beibehält, oder wobei das Klemmmittel das Mittel für das Tragen in einer vorher eingestellten Position hält, die eine (vor)gebogene Position entlang von deren axialen Länge ist.

2. Vorrichtung zur Behandlung eines zylindrisch geformten Elementes, die aufweist:
ein Mittel für das Tragen des Elementes durch Kontaktieren eines ersten Teils einer inneren Fläche des Elementes, wobei das Mittel für das Tragen eine axiale Länge aufweist;
ein Mittel für das Bereitstellen eines Behandlungsmittels benachbart einer äußeren Fläche des Elementes entgegengesetzt der inneren Fläche, wobei das Mittel für das Bereitstellen eine axiale Länge aufweist, die ausgebildet ist, um einen Kontaktklemmpunkt zwischen dem Behandlungsmittel und der äußeren Fläche entlang der axialen Länge des Mittels für das Tragen zu bilden;
**dadurch gekennzeichnet, dass** sie außerdem aufweist:
ein Klemmmittel für das Vorspannen des Mittels für das Bereitstellen in einer vorher eingestellten Position an einem Ende davon, und ausgebildet, um sich um das Mittel für das Bereitstellen herum zu öffnen und zu schließen,
wobei das Klemmmittel die axiale Länge des Mittels für das Bereitstellen in seiner vorher eingestellten Position parallel zur axialen Länge des Mittels für das Tragen nicht verschiebbar beibehält, oder wobei das Klemmmittel das Mittel für das Bereitstellen in einer vorher eingestellten Position hält, die eine (vor)gebogene Position entlang von deren axialen Länge ist.

3. Vorrichtung nach Anspruch 1 oder Anspruch 2, bei der das Klemmmittel eine Klemmenanordnung von mindestens zwei Festklemmvorrichtungen aufweist, die voneinander getrennt sind.

4. Vorrichtung nach Anspruch 3, bei der mindestens eine der Festklemmvorrichtungen eine obere Halterung mit einer Aussparung und eine untere Halterung mit einer Aussparung aufweist, wobei die obere Halterung und die untere Halterung ausgebildet sind, um in Eingriff zu kommen und einen Durchgang von Aussparungen zu bilden, um das Mittel für das Tragen aufzunehmen.

5. Vorrichtung nach Anspruch 3, bei der die Klemmenanordnung eine erste Festklemmvorrichtung und eine zweite Festklemmvorrichtung auf einer Plattform aufweist, wobei die erste Festklemmvorrichtung eine obere Halterung und eine untere Halterung mit einem Durchgang in einer Höhe h1 von der Plattform aus aufweist; wobei die zweite Festklemmvorrichtung eine obere Halterung und eine untere Halterung mit einem Durchgang in einer Höhe h2 von der Plattform aus aufweist, und wobei h1 und h2 unterschiedlich sind.

6. Vorrichtung nach Anspruch 1, die außerdem ein zweites Klemmmittel an einem zweiten Ende des Mittels für das Tragen entgegengesetzt dem einen Ende davon aufweist.

7. Vorrichtung nach Anspruch 1, bei der das Mittel für das Tragen aus der Gruppe ausgewählt wird, die besteht aus: einer Trommel; einer Rolle; einer Vielzahl von Rollen; und einem Plattformelement.

8. Verfahren zur Behandlung eines zylindrisch geformten Elementes, wobei das Verfahren die folgenden Schritte aufweist:
Tragen des Elementes mittels eines Trageelementes durch Kontaktieren einer inneren Fläche des Elementes, wobei das Trageelement eine axiale Länge aufweist;
Bereitstellen eines Behandlungsmittels benachbart einer äußeren Fläche des Elementes entgegengesetzt der inneren Fläche mit einem Kontaktelement mit einer axialen Länge, ausgebildet, um einen Kontaktklemmpunkt zwischen dem Behandlungsmittel und der äußeren Fläche entlang der axialen Länge des Kontaktelementes zu bilden; und
Festklemmen, um das Trageelement in eine vorher eingestellte Position an einem Ende davon vorzuspannen, und ausgebildet, um sich um das Trageelement herum zu öffnen und zu schließen,
wobei das Klemmmittel die axiale Länge des Trageelementes in seiner vorher eingestellten Position parallel zur axialen Länge des Kontaktelementes nicht verschiebbar beibehält, oder
wobei das Klemmmittel das Trageelement entlang von dessen axialer Länge vorbiegt.

9. Verfahren zur Behandlung eines zylindrisch geformten Elementes, wobei das Verfahren die folgenden Schritte aufweist:
Tragen des Elementes mittels eines Trageelementes durch Kontaktieren einer inneren Fläche des Elementes, wobei das Trageelement eine axiale Länge aufweist;
Bereitstellen eines Behandlungsmittels benachbart einer äußeren Fläche des Elementes entgegengesetzt der inneren Fläche mit einem Kontaktelement mit einer axialen Länge, ausgebildet, um einen Kontaktklemmpunkt zwischen dem Behandlungsmittel und der äußeren Fläche entlang der axialen Länge des Kontaktelementes zu bilden; und
Festklemmen, um das Kontaktelement in eine vorher eingestellte Position an einem Ende davon vorzuspannen, und ausgebildet, um sich um das Kontaktelement herum zu öffnen und zu schließen,
wobei das Klemmmittel die axiale Länge des Kontaktelementes in seiner vorher eingestellten Position parallel zur axialen Länge des Trageelementes nicht verschiebbar beibehält, oder
wobei das Klemmmittel das Kontaktelement entlang von dessen axialer Länge vorbiegt.

## Revendications

1. Appareil pour traiter un élément de forme cylindrique, comprenant :
un moyen pour supporter l'élément en contactant une première partie d'une surface interne de l'élément, le moyen de support ayant une longueur axiale ;
un moyen pour fournir un agent de traitement près d'une surface externe de l'élément, opposée à la surface interne, le moyen de fourniture ayant une longueur axiale adaptée pour former un espace de contact entre l'agent de traitement et la surface externe le long de la longueur axiale du moyen de support ;
**caractérisé en ce qu'**il comprend en outre :
un moyen de serrage, pour pousser le moyen de support vers une position préréglée au niveau d'une de ses extrémités, et adapté pour s'ouvrir et se fermer autour du moyen de support ;
dans lequel le moyen de serrage maintient la longueur axiale du moyen de support dans un étant rigide dans sa position préréglée, parallèle à la longueur axiale du moyen de fourniture, ou dans lequel le moyen de serrage maintient le moyen de support dans une position préréglée, constituant une position (pré)fléchie le long de sa longueur axiale.

2. Appareil pour traiter un élément de forme cylindrique, comprenant :
un moyen pour supporter l'élément en contactant une première partie d'une surface interne de l'élément, le moyen de support ayant une longueur axiale ;
un moyen pour fournir un agent de traitement près d'une surface externe de l'élément, opposée à la surface interne, le moyen de fourniture ayant une longueur axiale adaptée pour former un espace de contact entre l'agent de traitement et la surface externe le long de la longueur axiale du moyen de support ;
**caractérisé en ce qu'**il comprend en outre :
un moyen de serrage, pour pousser le moyen de fourniture vers une position préréglée au niveau d'une de ses extrémités, et adapté pour s'ouvrir et se fermer autour du moyen de fourniture ;
dans lequel le moyen de serrage maintient la longueur axiale du moyen de fourniture dans un état rigide dans sa position préréglée, parallèle à la longueur axiale du moyen de support, ou dans lequel le moyen de serrage maintient le moyen de fourniture dans une position préréglée, constituant une position (pré)fléchie le long de sa longueur axiale.

3. Appareil selon les revendications 1 ou 2, dans lequel le moyen de serrage comprend un assemblage de serrage d'au moins deux dispositifs de serrage, séparés l'un de l'autre.

4. Appareil selon la revendication 3, dans lequel au moins un des dispositifs de serrage comprend une console supérieure comportant un évidement, et une console inférieure comportant un évidement, la console supérieure et la console inférieure étant adaptées pour s'accoupler et pour former un passage des évidements afin de retenir le moyen de support.

5. Appareil selon la revendication 3, dans lequel l'assemblage de serrage comprend un premier dispositif de serrage et un deuxième dispositif de serrage sur une plate-forme, le premier dispositif de serrage comprenant une console supérieure et une console inférieure comportant un passage au niveau d'une hauteur h1 par rapport à la plate-forme ; le deuxième dispositif de serrage comprenant une console supérieure et une console inférieure comportant un passage au niveau d'une hauteur h2 par apport à la plate-forme, et dans lequel les hauteurs h1 et h2 sont différentes.

6. Appareil selon la revendication 1, comprenant en outre un deuxième moyen de serrage au niveau d'une deuxième extrémité du moyen de support, opposée à ladite une extrémité de celui-ci.

7. Appareil selon la revendication 1, dans lequel le moyen de support est sélectionné dans le groupe constitué d'un tambour, d'un rouleau, d'une pluralité de rouleaux et d'un élément de plate-forme.

8. Procédé de traitement d'un élément de forme cylindrique, ledit procédé comprenant les étapes ci-dessous :
supporter l'élément par un élément de support, en contactant une surface interne de l'élément, l'élément de support ayant une longueur axiale ;
fournir un agent de traitement près d'une surface externe de l'élément, opposée à la surface interne, comportant un élément de contact ayant une longueur axiale adaptée pour former un espace de contact entre l'agent de traitement et la surface externe, le long de la longueur axiale de l'élément de contact ; et
serrer pour pousser l'élément de support vers une position préréglée au niveau d'une de ses extrémités, et adapté pour s'ouvrir et se fermer autour de l'élément de support ;
dans lequel le moyen de serrage maintient la longueur axiale de l'élément de support dans un état rigide dans sa position préréglée, parallèle à la longueur axiale de l'élément de contact ; ou bien :
dans lequel le moyen de serrage assure un fléchissement préalable de l'élément de support le long de sa longueur axiale.

9. Procédé de traitement d'un élément de forme cylindrique, ledit procédé comprenant les étapes ci-dessous :
supporter l'élément par un élément de support, en contactant une surface interne de l'élément, l'élément de support ayant une longueur axiale ;
fournir un agent de traitement près d'une surface externe de l'élément, opposée à la surface interne, comportant un élément de contact ayant une longueur axiale adaptée pour former un espace de contact entre l'agent de traitement et la surface externe, le long de la longueur axiale de l'élément de contact ; et
serrer pour pousser l'élément de contact vers une position préréglée au niveau d'une de ses extrémités, et adapté pour s'ouvrir et se fermer autour de l'élément de contact,
dans lequel le moyen de serrage maintient la longueur axiale de l'élément de contact dans un état rigide dans sa position préréglée, parallèle à la longueur axiale de l'élément de support, ou
dans lequel le moyen de serrage assure un fléchissement préalable de l'élément de contact le long de sa longueur axiale.
